# FASCICULE DE BREVET EUROPEEN

(11) **EP 0 783 110 B1**
(45) Date de publication et mention de la délivrance du brevet: **28.08.2002**
(21) Numéro de dépôt: 97400003.6
(22) Date de dépôt: 02.01.1997
(51) Int. Cl.: G01R 15/20

(54) **Capteur de courant à large gamme de fonctionnement**
Stromfühler mit grossem Betriebsbereich
Current sensor having a wide range of operation

(30) Priorité: 05.01.1996 FR 9600065
(43) Date de publication de la demande: 09.07.1997
(73) Titulaire: ABB CONTROL, F-69680 Chassieu (FR)
(72) Inventeur: Marciot, Denis, 69003 Lyon (FR)
(74) Mandataire: Laget, Jean-Loup

(56) Documents cités:
- EP-A- 0 392 439
- US-A- 5 477 135
- GHISLANZONI L: "MAGNETIC COUPLED CURRENT SENSING TECHNIQUES FOR SPACECRAFT POWER SYSTEMS" 2 Octobre 1989 , EUROPEAN SPACE POWER, MADRID, OCT. 2 - 6, 1989, VOL. 1, PAGE(S) 323 - 327 , LANDEAU J XP000163967 * page 323 - page 324; figures 1-3,6 *

## Description

L'invention concerne un capteur de courant à large gamme de fonctionnement, et plus particulièrement un capteur de courant pour la protection et la commande d'un moteur.

Pour contrôler le courant absorbé par un moteur, il est nécessaire de disposer d'un capteur qui puisse mesurer avec précision le courant nominal relativement faible du moteur, mais aussi le courant de démarrage du moteur, qui peut atteindre dix fois la valeur du courant nominal.

Les capteurs de courant généralement utilisés comportent un tore ferromagnétique dans l'entrefer duquel est disposée une sonde à effet Hall. Cette sonde délivre une tension proportionnelle à l'induction magnétique créée par le courant à mesurer, ou courant primaire.

Un premier type de capteur de courant effectue la mesure du courant en boucle ouverte, et délivre une tension de sortie proportionnelle au courant primaire.

Pour assurer cette proportionnalité, le circuit magnétique doit être très bien défini, et la sonde doit être très linéaire et doit pouvoir mesurer des inductions élevées.

Un deuxième type de capteur de courant effectue la mesure du courant en boucle fermée, et délivre un courant secondaire proportionnel au courant primaire à mesurer. Lorsque le courant primaire augmente, une saturation du circuit électronique entraîne une perte de linéarité de la mesure.

Le document EP-0 392 439 A décrit un dispositif à transformateur d'intensité de courant à tore ferromagnétique à entrefer, pour la mesure d'un courant électrique variable comportant une composante à basse fréquence et une composante à fréquences élevées superposée.

Un transformateur de courant délivre aux bornes d'une résistance une tension proportionnelle à la composante à fréquences élevées ; une sonde de Hall et un amplificateur proportionnel délivrent une tension correspondant à la fréquence basse ; et les deux tensions sont additionnées.

Un tel circuit permet de mesurer l'intensité d'un courant à fréquences variables mais ne permet pas d'assurer une bonne linéarité dans une large gamme d'intensités du courant primaire.

Un but de l'invention est d'éviter les inconvénients des capteurs connus en proposant un capteur susceptible d'assurer une mesure linéaire dans une gamme étendue de courants primaires.

Un autre but de l'invention est de proposer un capteur utilisable pour la protection et la commande de moteurs, aussi bien en fonctionnement normal que pendant la période de démarrage.

L'invention a pour objet un capteur de courant, fonctionnant dans une large gamme d'intensités de courant, correspondant à un rapport d'intensités voisin de 100 à 1 comportant :
- un tore (1) ferromagnétique à entrefer disposé autour d'un conducteur (2) parcouru par le courant primaire d'intensité Ip à mesurer,
- une sonde de Hall (3) disposée dans l'entrefer du tore (1) et délivrant, par l'intermédiaire d'un amplificateur (4) une tension V_{BO} correspondant à l'induction magnétique dans l'entrefer,
- une bobine (9) enroulée autour du tore (1) et montée en série avec une résistance (10),
caractérisé en ce que :
- entre la bobine (9) et la résistance (10) est monté un circuit électronique comportant un amplificateur (6) et un condensateur (8) de contre-réaction, pour constituer une boucle d'asservissement fermée fournissant aux bornes de la résistance (10) une tension V_{BF} correspondant à l'intensité Ip du courant primaire,
les tensions V_{BO} et V_{BF} étant additionnées dans un additionneur (11) pour constituer une tension de sortie V_{S} proportionnelle à l'intensité Ip du courant primaire, avec le même coefficient de proportionnalité aussi bien pour les faibles valeur de l'intensité Ip, pour lesquelles la tension V_{BO} est pratiquement nulle, que pour les fortes valeurs de l'intensité Ip.

Selon l'invention, le gain de l'amplificateur (4) est déterminé pour que la tension de sortie Vₛ soit proportionnelle à l'intensité Iₚ du courant primaire, avec le même coefficient de proportionnalité, aussi bien pour les faibles valeurs du courant primaire, pour lesquelles la tension Vₛₒ délivrée par l'amplificateur est pratiquement nulle, que pour les fortes valeurs du courant primaire.

D'autres caractéristiques ressortent de la description qui suit faite avec référence aux dessins annexés dans lesquels :
- la figure 1 est un schéma simplifié d'un capteur de courant de type à boucle ouverte ;
- la figure 2 est un schéma simplifié d'un capteur de courant de type à boucle fermée ;
- la figure 3 est un schéma simplifié d'un exemple de réalisation d'un capteur de courant selon l'invention.

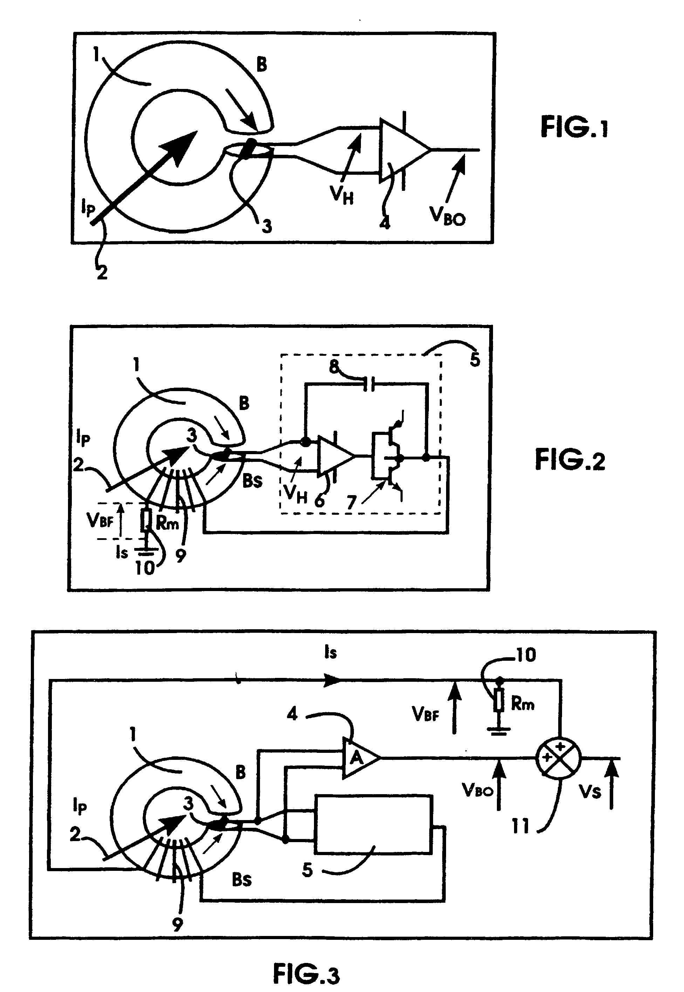

Sur la figure 1, un tore ferromagnétique 1 est disposé autour d'un conducteur 2 parcouru par un courant primaire Ip. Dans l'entrefer du tore est disposée une sonde de Hall 3, reliée à un amplificateur 4. Le courant primaire Ip crée une induction magnétique B proportionnelle au courant primaire Ip. Sous l'effet de cette induction, la sonde de Hall délivre une tension V_{H} proportionnelle à l'induction magnétique B. La tension V_{H} est amplifiée par l'amplificateur 4 qui délivre en sortie une tension V_{BO} proportionnelle au courant primaire Ip. Le capteur à boucle ouverte (BO) de la figure 1 assure une bonne linéarité de réponse entre la tension de sortie V_{BO} et l'intensité du courant primaire Ip, il fonctionne bien pour les intensités élevées, mais ne peut guère couvrir qu'une gamme d'intensités primaires dans un rapport inférieur à 20 : 1.

Sur la figure 2, un tore ferromagnétique 1 est disposé autour d'un conducteur 2 parcouru par un courant primaire Ip. Dans l'entrefer du tore est disposée une sonde de Hall 3 reliée à un circuit électronique 5. Ce circuit électronique 5 comprend un amplificateur 6, un circuit générateur de courant 7, et un condensateur 8 de contre-réaction.

La sortie du circuit électronique 5 est reliée à une bobine 9 enroulée autour du tore 1 et montée en série avec une résistance 10 reliée à la masse.

Le circuit électronique 5 délivre un courant secondaire Is. Ce courant Is en circulant dans la bobine 9 crée une induction magnétique Bs de sens opposé à l'induction B créée par le courant primaire Ip, et de même amplitude que l'induction B.

Le courant secondaire Is est alors proportionnel au courant primaire Ip. Le capteur à boucle d'asservissement fermée (BF) de la Figure 2 assure une bonne linéarité de réponse entre l'intensité du courant de sortie Is et l'intensité du courant primaire Ip. Il fonctionne bien pour les intensités faibles du courant primaire.

Le circuit électronique 5 est alimenté en courant continu sous quelques volts. De ce fait, lorsque l'intensité du courant primaire Ip augmente, le circuit électronique 5 ne peut plus fournir l'intensité du courant secondaire Is suffisante pour que l'amplitude de l'induction Bs créée par la bobine 9 soit égale à celle de l'induction B créée par le courant primaire Ip. Il en résulte une saturation du circuit électronique et une perte de la linéarité de réponse. Le capteur de courant à boucle fermée de la figure 2 fonctionne bien pour les intensités faibles, mais ne peut guère couvrir qu'une gamme d'intensités primaires dans un rapport inférieur à 20 : 1.

Sur la figure 3, le tore ferromagnétique 1 est disposé autour d'un conducteur 2 parcouru par le courant primaire Ip. Dans l'entrefer du tore 1, est disposée une sonde de Hall 3. Cette sonde de Hall 3 est reliée en dérivation, d'une part à un amplificateur 4 comme celui de la figure 1, d'autre part à un circuit électronique 5 comme celui de la figure 2. La sortie du circuit électronique 5 alimente une bobine 9 montée en série avec une résistance 10 reliée à la masse.

Le courant secondaire Is traverse la résistance 10, et la tension V_{BF} mesurée aux bornes de la résistance 10 est proportionnelle au courant secondaire. Cette tension V_{BF} est additionnée, dans un additionneur 11, à la tension V_{BO} de sortie de l'amplificateur 4. Cette tension V_{BO} correspond à la tension de sortie de la sonde à effet Hall, amplifiée par le gain de l'amplificateur 4.

La tension de sortie Vs de l'additionneur 11 est la somme des deux tensions V_{BO}, représentative de l'induction dans l'entrefer, et V_{BF}, représentative du courant primaire.

Le fonctionnement du capteur de courant selon l'invention s'analyse de la manière suivante :

Pour de faibles valeurs de courant primaire Ip, la boucle d'asservissement comprenant le circuit électronique 5 et la bobine 9 fonctionne efficacement. L'induction résultante dans le tore 1 est nulle et, en conséquence, la tension aux bornes de la sonde de Hall 3 est nulle. Il en résulte que la tension de sortie V_{BO} de l'amplificateur 4 est nulle et que la tension de sortie Vₛ est égale à la tension V_{BF} aux bornes de la résistance 10. Le capteur fonctionne en boucle fermée.

Si le courant primaire Ip augmente, le circuit électronique 5 est soumis à saturation, la boucle d'asservissement ne parvient à compenser que partiellement l'induction dans le tore 1. La tension aux bornes de la sonde de Hall 3 n'est plus nulle mais proportionnelle à l'induction magnétique résultante.

L'amplificateur 4 joue alors un rôle et délivre une tension V_{BO}. Selon l'invention, le gain A de l'amplificateur 4 est déterminé pour que la tension V_{BO}, en s'ajoutant à la tension V_{BF} dans l'additionneur 11, reconstitue la tension de sortie Vs sous une forme proportionnelle au courant primaire Ip, avec le même coefficient de proportionnalité que pour les courants primaires de faible intensité.

De cette manière, pour un courant primaire Ip faible, le capteur fonctionne en boucle fermée et sa tension de sortie est : Vs = V_{BF}
avec Vs = K Ip (K = coefficient de proportionnalité)

Et lorsque le courant primaire augmente, la tension de sortie devient : Vs = V_{BF} + V_{BO}
avec toujours Vs = K Ip
le coefficient de proportionnalité étant le même.

La tension de sortie Vs représentative de l'intensité du courant primaire Ip est alors constituée de deux composantes V_{BF} et V_{BO} qui s'additionnent pour reconstituer une tension de sortie Vs proportionnelle au courant primaire. Cette disposition permet de mesurer des intensités de courant primaire avec une bonne linéarité, dans un rapport voisin de 100 : 1.

## Revendications

1. Capteur de courant, fonctionnant dans une large gamme d'intensités de courant, correspondant à un rapport d'intensités voisin de 100 à 1 comportant :
- un tore (1) ferromagnétique à entrefer disposé autour d'un conducteur (2) parcouru par le courant primaire d'intensité Ip à mesurer,
- une sonde de Hall (3) disposée dans l'entrefer du tore (1) et délivrant, par l'intermédiaire d'un amplificateur (4) une tension V_{BO} correspondant à l'induction magnétique dans l'entrefer,
- une bobine (9) enroulée autour du tore (1) et montée en série avec une résistance (10),
**caractérisé en ce que** :
- entre la bobine (9) et la résistance (10) et relié avec la bobine (9) et la sonde de Hall (3) est monté un circuit électronique (5) comportant un amplificateur (6) et un condensateur (8) de contre-réaction, pour constituer une boucle d'asservissement fermée fournissant aux bornes de la résistance (10) une tension V_{BF} correspondant à l'intensité Ip du courant primaire,
- les tensions V_{BO} et V_{BF} étant additionnées dans un additionneur (11) pour constituer une tension de sortie V_{S} proportionnelle à l'intensité Ip du courant primaire, avec le même coefficient de proportionnalité aussi bien pour les faibles valeurs de l'intensité Ip, pour lesquelles la tension V_{BO} est pratiquement nulle, que pour les fortes valeurs de l'intensité Ip.

## Claims

1. A current sensor having a wide range of operation for current intensities corresponding to an intensity ratio of 100 to 1, comprising:
- a ferro-magnetic core (1) with an air gap placed around a conductor (2) through which passes the primary current Ip to be measured,
- a Hall probe (3) placed in the air gap of the core (1) producing, through an amplifier (4), a voltage V_{BO} representing the magnetic induction in the air gap,
- a winding (9) wound around the core (1) and connected in series with a resistor (10),
**characterised by**:
- an electronic circuit connected with the winding (9) and with the Hall probe (3), between the winding (9) and the resistor (10), and comprising an amplifier (6) and a negative feedback capacitor (8) so as to constitute a closed servo loop that over the terminals of the resistor (10) provides a voltage V_{BF} representing the intensity Ip of the primary current,
- the voltages V_{BO} and V_{BF} being summed in an adder (11) to produce an output voltage Vₛ proportional to the intensity Ip of the primary current, with the same meter constant as well for the low values of the intensity Ip, for which the voltage V_{BO} is practically zero, as for the high values of the intensity Ip.

## Patentansprüche

1. Stromaufnehmer mit einem großen Stromstärken-Arbeitsbereich entsprechend einem Stromstärkeverhältnis nahe 100:1, umfassend
- einen ferromagnetischen Ring (1) mit Luftspalt, der einen Leiter (2) umgibt, in dem der Primärstrom mit der zu messenden Stromstärke Ip fließt,
- eine Hall-Sonde (3), die im Luftspalt des Rings (1) angeordnet ist und über einen Verstärker (4) eine Spannung V_{BO} liefert, die der magnetischen Induktion im Luftspalt entspricht,
- eine Wicklung (9), die den Ring (11) umgibt und in Serie mit einem Widerstand (10) geschaltet ist,
**dadurch gekennzeichnet, daß**:
- eine elektrische Schaltung (5) zwischen der Wicklung (9) und dem Widerstand (10) angeordnet und mit der Wicklung (9) und der Hall-Sonde (3) verbunden ist, mit einem Verstärker (6) und einem Rückkoppelungskondensator (8) zur Bildung einer geschlossenen Regelschleife, die den Klemmen des Widerstands (10) eine Spannung V_{BF} zuführt, die der Stromstärke Ip des Primärstroms entspricht,
- wobei die Spannungen V_{BO} und V_{BF} in einem Summierglied (11) addiert werden, um eine Ausgangsspannung V_{S} proportional zur Stärke Ip des Primärstroms zu bilden, mit dem gleichen Proportionalitätskoeffizienten sowohl für geringe Werte der Stromstärke Ip, bei denen die Spannung V_{BO} praktisch Null ist, also auch für die hohen Werte der Stromstärke Ip.
